# EUROPEAN PATENT SPECIFICATION

(11) **EP 2 315 244 B1**
(45) Date of publication and mention of the grant of the patent: **26.02.2020**
(21) Application number: 10188781.8
(22) Date of filing: 26.10.2010
(51) Int. Cl.: H01L 23/473, H01L 23/367

(54) **Liquid-cooled-type cooling device**
Kühlgerät mit Flüssigkeitskühlung
Dispositif refroidissant de type refroidissement par liquide

(30) Priority: 26.10.2009 JP 2009245319
(43) Date of publication of application: 27.04.2011
(73) Proprietor: Showa Denko K.K., Tokyo 105-8518 (JP)
(72) Inventor: Mori, Shogo, Aichi 448-8671 (JP); Ito, Satoshi, Aichi 448-8671 (JP); Matsushima, Seiji, Tochigi 323-8678 (JP); Kuribayashi, Taizo, Tochigi 323-8678 (JP)
(74) Representative: Cabinet Beau de Loménie

(56) References cited:
- EP-A1- 1 739 378
- WO-A1-2005/038375
- WO-A1-2009/069578
- WO-A2-2009/078289
- DE-U1-202007 017 501
- JP-A- 2004 263 616
- JP-A- 2009 081 220
- US-A- 5 625 229

## Description

### BACKGROUND OF THE INVENTION

The present invention relates to a liquid-cooled-type cooling device which is applied to a semiconductor power converter of a vehicle or the like and which is adapted to cool a heat-generating body such as a semiconductor device.

Japanese Patent Application Laid-Open *(kokai)* No. 2007-201181 discloses a conventional liquid-cooled-type cooling device of the above-mentioned type. The conventional liquid-cooled-type cooling device includes a casing which has a top wall, a bottom wall, and a peripheral wall and on which a cooling-liquid inlet and a cooling-liquid outlet are formed, wherein a cooling-liquid flow channel is provided within the casing at a position between the cooling-liquid inlet and the cooling-liquid outlet. A heat-generating body is attached to an outer surface of the top or bottom wall of the casing. On an inner surface of a portion of the wall facing the cooling-liquid flow channel, a plurality of fins are provided such that they project into the cooling-liquid flow channel, extend in a flow direction of cooling liquid within the cooling-liquid flow channel, and are spaced from one another in the width direction of the cooling-liquid flow channel. Each fin has a wavy shape as viewed on a cross section taken along a horizontal plane perpendicularly intersecting the height direction of the fin, and has wave crest portions and wave trough portions formed alternately. A first fin of two adjacent fins is configured such that second-fin-side surfaces of two slant portions connecting two adjacent wave trough portions and a wave crest portion positioned between the two wave trough portions intersect the above-mentioned horizontal plane, whereby two lines of intersection are formed between the second-fin-side surfaces and the horizontal plane and intersect each other at a first point. The second fin of the two adjacent fins is configured such that first-fin-side surfaces of two slant portions connecting two adjacent wave crest portions and a wave trough portion positioned between the two wave crest portions intersect the above-mentioned horizontal plane, whereby two lines of intersection are formed between the first-fin-side surfaces and the horizontal plane and intersect each other at a second point. The two adjacent fins are arranged such that the first point is located on the first fin side in relation to the second point.

In the liquid-cooled-type cooling device described in the publication, the fins provided in the cooling-liquid flow channel are formed into a way shape so as to increase the fin area, to thereby improve cooling performance.

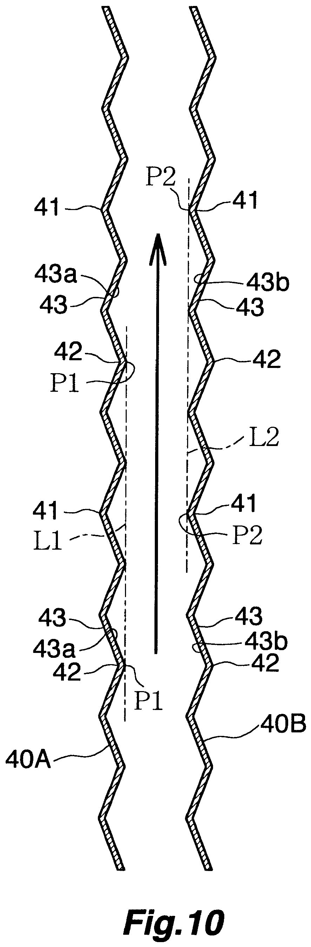

Incidentally, in the liquid-cooled-type cooling device described in the publication, as shown in Fig. 10, of two fins 40A and 40B, the left fin 40A is configured such that right side surfaces 43a of two slant portions 43 connecting two adjacent wave trough portions 42 and a wave crest portion 41 located between the two wave trough portions 42 intersect the above-mentioned horizontal line, whereby two lines of intersection are formed between the right side surfaces 43a and the horizontal plane and intersect each other at a first point P1. This first point P1 is located on a first straight line L1 extending in a front-rear direction. The right fin 40B is configured such that left side surfaces 43b of two slant portions 43 connecting two adjacent wave crest portions 41 and a wave trough portion 42 located between the two wave crest portions 41 intersect the above-mentioned horizontal line, whereby two lines of intersection are formed between the left side surfaces 43b and the horizontal plane and intersect each other at a second point P2. This second point P2 is located on a second line L2 extending in the front-rear direction. The first straight line L1 is located on the left side of the second straight line L2 with a relatively large spacing therebetween, whereby the above-mentioned point P1 of the left fin 40A is located leftward of the above-mentioned point P2 of the right fin 40B. Therefore, cooling liquid tends to flow straight between the two fins 40A and 40B, and is unlikely to flow along the fins 40A and 40B. Accordingly, the areas of the fins 40A and 40B which effectively act for heat transmission do not increase effectively, which limits the effect of improving cooling performance.

From the prior art a liquid-cooled-type cooling device according to the preamble of claim 1 is known. Documents EP1739378 and JP2009081220 disclose a liquid-cooled-type cooling device.

To achieve the above object, the present invention includes the following modes.
1) A liquid-cooled-type cooling device including a casing which has a top wall, a bottom wall, and a peripheral wall, which has a cooling-liquid inlet and a cooling-liquid outlet formed thereon, and in which a cooling-liquid flow channel is provided between the cooling-liquid inlet and the cooling-liquid outlet, wherein
   a plurality of fins projecting into the cooling-liquid flow channel and extending in a flow direction of cooling liquid within the cooling-liquid flow channel are provided on an inner surface of a portion of a wall selected from the top wall and the bottom wall of the casing onto which a heat-generating body is attached such that the heat-generating body is in contact with an outer surface of the selected wall, the potion of the selected wall facing the cooling-liquid flow channel, and the plurality of fins being spaced from one another in a width direction of the cooling-liquid flow channel;
   each of the fins has a wavy shape as viewed on a cross section taken along a horizontal plane perpendicular to a height direction of the fins, and has wave crest portions and wave trough portions alternately formed thereon; and
   the fins are configured and arranged such that the cooling liquid flows between two adjacent fins while meandering.
2) A liquid-cooled-type cooling device according to par. 1), wherein a first fin of two adjacent fins is configured such that two lines of intersection formed between the horizontal plane and second-fin-side surfaces of two slant portions connecting two adjacent wave crest portions and a wave trough portion located therebetween intersect each other at a point located on a first straight line; a second fin of the two adjacent fins is configured such that two lines of intersection formed between the horizontal plane and first-fin-side surfaces of two slant portions connecting two adjacent wave trough portions and a wave crest portion located therebetween intersect each other at a point located on a second straight line; and the first straight line and the second straight line coincide with each other or the first straight line is located on a side toward the second fin in relation to the second straight line.
3) A liquid-cooled-type cooling device according to par. 2), wherein the wave crest portions and the wave trough portions of each fin are rounded; and, as viewed on the horizontal plane, the point at which the two lines of intersection between the horizontal plane and the second-fin-side surfaces of the two slant portions intersect each other is located at a position at which imaginary lines extending toward the second fin from the second-fin-side surfaces of the two slant portions intersect each other.
4) A liquid-cooled-type cooling device according to par. 2), wherein the wave crest portions and the wave trough portions of each fin are made flat; and, as viewed on the horizontal plane, the point at which the two lines of intersection between the horizontal plane and the second-fin-side surfaces of the two slant portions intersect each other is located at a position at which imaginary lines extending toward the second fin from the second-fin-side surfaces of the two slant portions intersect each other.
5) A liquid-cooled-type cooling device according to par. 2), wherein the first fin of two adjacent fins is configured such that the two lines of intersection formed between the horizontal plane and the second-fin-side surfaces of two slant portions connecting two adjacent wave trough portions and a wave crest portion located therebetween form an angle of 110 to 150 degrees therebetween; and the second fin of the two adjacent fins is configured such that the two lines of intersection formed between the horizontal plane and the first-fin-side surfaces of two slant portions connecting two adjacent wave crest portions and a wave trough portion located therebetween form an angle of 110 to 150 degrees therebetween.
6) A liquid-cooled-type cooling device according to par. 2), wherein two adjacent fins have a spacing of 0.5 mm or greater therebetween.
7) A liquid-cooled-type cooling device according to par. 2), wherein two adjacent fins are connected together at their upper end portions or lower end portions via a connection portion, and a plurality of the connection portions are provided at upper and lower end portions, alternately, of all the fins, whereby all the fins and the connection portions constitute a fin unit; and the connection portions on the upper side of the fin unit are joined to the top wall of the casing, and the connection portions on the lower side of the fin unit are joined to the bottom wall of the casing.

According to the liquid-cooled-type cooling device of par. 1), a plurality of fins projecting into the cooling-liquid flow channel and extending in a flow direction of cooling liquid within the cooling-liquid flow channel are provided on an inner surface of a portion of a wall selected from the top wall and the bottom wall of the casing onto which a heat-generating body is attached such that the heat-generating body is in contact with an outer surface of the selected wall, the potion of the selected wall facing the cooling-liquid flow channel, and the plurality of fins being spaced from one another in a width direction of the cooling-liquid flow channel; each of the fins has a wavy shape as viewed on a cross section taken along a horizontal plane perpendicular to a height direction of the fins, and has wave crest portions and wave trough portions alternately formed thereon; and the fins are configured and arranged such that the cooling liquid flows between two adjacent fins while meandering. Therefore, the cooling liquid becomes likely to flow along the wavy fins. Accordingly, the areas of the fins which effectively act for heat transmission increase effectively, whereby cooling performance can be improved.

According to the liquid-cooled-type cooling devices of pars. 2) to 7), a first fin of two adjacent fins is configured such that two lines of intersection formed between the horizontal plane and second-fin-side surfaces of two slant portions connecting two adjacent wave crest portions and a wave trough portion located therebetween intersect each other at a point located on a first straight line; a second fin of the two adjacent fins is configured such that two lines of intersection formed between the horizontal plane and first-fin-side surfaces of two slant portions connecting two adjacent wave trough portions and a wave crest portion located therebetween intersect each other at a point located on a second straight line; and the first straight line and the second straight line coincide with each other or the first straight line is located on a side toward the second fin in relation to the second straight line. Therefore, the cooling liquid flows between two adjacent fins while meandering. Accordingly, the cooling liquid becomes likely to flow along the wavy fins, and the areas of the fins which effectively act for heat transmission increase effectively, whereby cooling performance can be improved.

According to the liquid-cooled-type cooling device of par. 5), cooling performance can be improved maximally, while an increase in pressure loss produced when the cooling liquid flows between two adjacent fins is suppressed effectively.

According to the liquid-cooled-type cooling device of par. 6), catching of a foreign object between two adjacent fins can be prevented effectively.

According to the liquid-cooled-type cooling device of par. 7), the fins can be readily provided within the casing.

### BRIEF DESCRIPTION OF THE DRAWINGS

Fig. 1 is a perspective view showing a liquid-cooled-type cooling device according to the present invention;
Fig. 2 is a sectional view taken along line A-A of Fig. 1;
Fig. 3 is a sectional view taken along line B-B of Fig. 2;
Fig. 4 is a perspective view showing a portion of a fin unit of the liquid-cooled-type cooling device of Fig. 1;
Fig. 5 is an enlarged view of a main portion of Fig. 3;

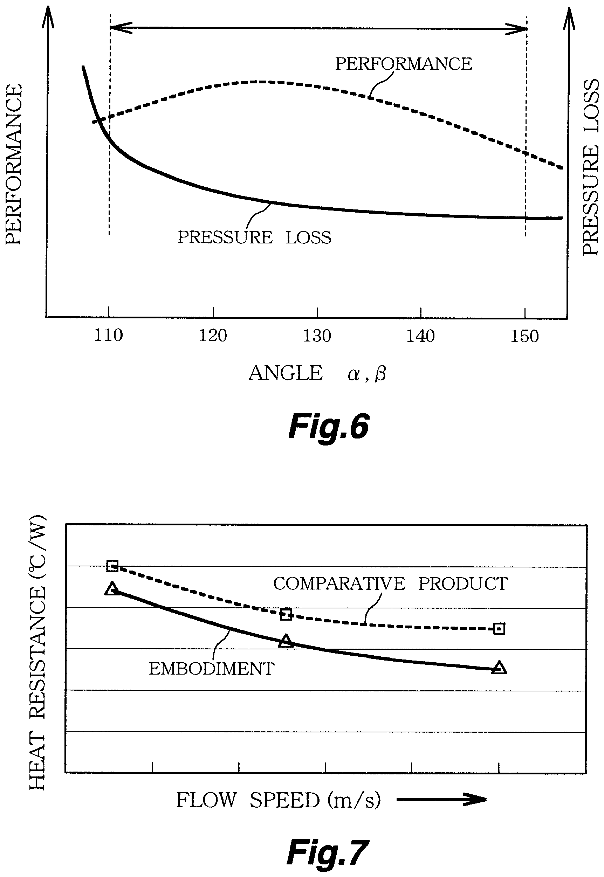

Fig. 6 is a graph showing the relation between cooling performance and pressure loss, and angles α and β of adjacent first and second fins, wherein the angle α of the first fin is an angle between lines of intersection formed between a horizontal plane and the second-fin-side surfaces of two slant portions of the first fin connecting two adjacent wave trough portions and a wave crest portion located therebetween, and the angle β of the second fin is an angle between lines of intersection formed between the horizontal plane and the first-fin-side surfaces of two slant portions of the second fin connecting two adjacent wave crest portions and a wave trough portion located therebetween;
Fig. 7 is a graph showing the relation between heat resistance and flow speed of cooling liquid flowing through a cooling-liquid flow channel for an embodiment and a comparative product;
Fig. 8 is a view corresponding to Fig. 5 and showing a modification of the fin unit;
Fig. 9 is a view corresponding to Fig. 5 and showing another modification of the fin unit; and
Fig. 10 is a view corresponding to Fig. 5 and showing fins of a conventional liquid-cooled-type cooling device.

### DESCRIPTION OF THE PREFERRED EMBODIMENT

An embodiment of the present invention will next be described with reference to the drawings. Notably, throughout the drawings, like portions and like members are indicated by like reference numerals, and repeated descriptions are omitted.

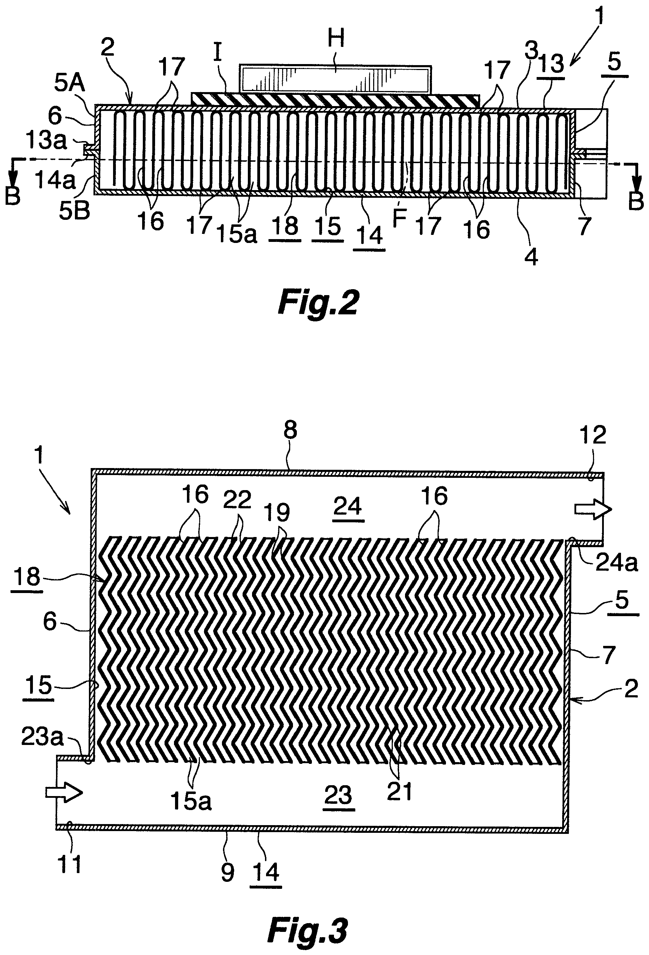

In the following description, the upper, lower, lefthand, and right-hand sides of Fig. 2 will be referred to as "upper," "lower," "left," and "right," respectively. Further, the lower and upper sides of Fig. 3 will be referred to as "front" and "rear," respectively.

In the following description, the term "aluminum" encompasses aluminum alloys in addition to pure aluminum.

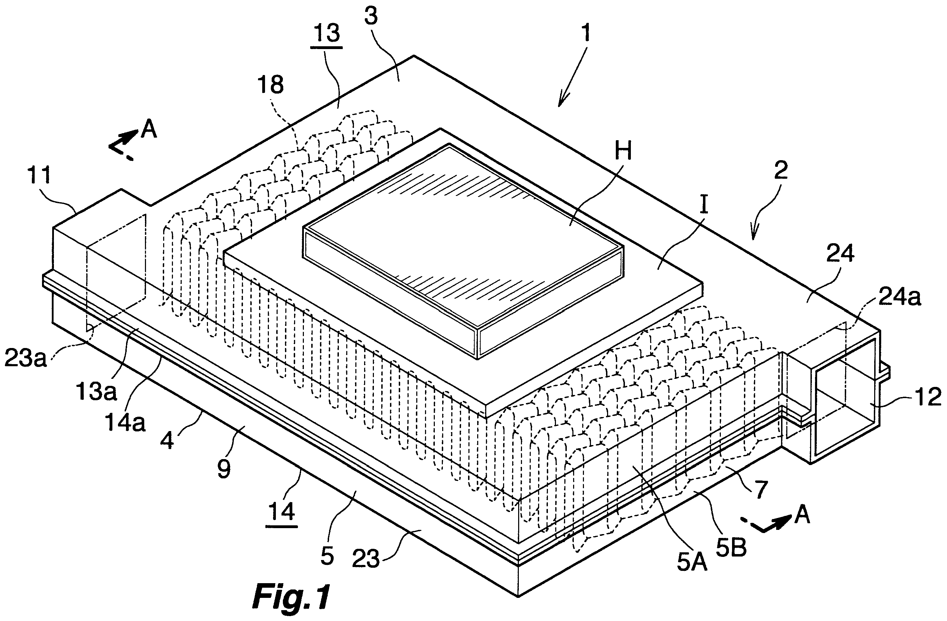

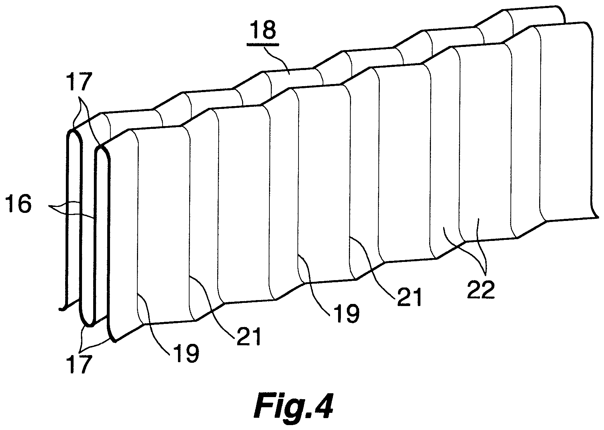

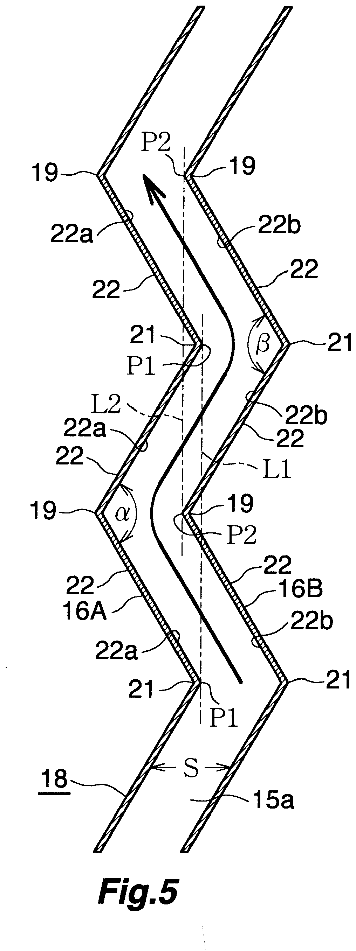

Figs. 1 to 3 show the overall structure of a liquid-cooled-type cooling device according to the present invention; and Figs. 4 and 5 show the structure of a main portion of the cooling device. Notably, Figs. 1 to 3 show a state in which a heat-generating body composed of a semiconductor device is mounted on the liquid-cooled-type cooling device of the present invention.

In Figs. 1 to 3, a liquid-cooled-type cooling device 1 has a casing 2 composed of a top wall 3, a bottom wall 4, and a peripheral wall 5. The peripheral wall 5 of the casing 2 includes a left side wall 6, which extends in the front-rear direction and stands vertically; a right side wall 7, which extends in the front-rear direction, stands vertically, and is positioned in opposition to the left side wall 6; a rear side wall 8, which extends in the left-right direction and stands vertically; and a front side wall 9, which extends in the left-right direction and stands vertically. In the peripheral wall 5 of the casing 2, a cooling-liquid inlet 11 is formed at a front end portion of the left side wall 6 in a leftward projecting condition, and a cooling-liquid outlet 12 is formed at a rear end portion of the right side wall 7 in a rightward projecting condition. The cooling-liquid inlet 11 opens leftward, whereas the cooling-liquid outlet 12 opens rightward. The casing 2 is formed of an upper structure member 13 of aluminum and a lower structure member 14 of aluminum. The upper structure member 13 includes the top wall 3 and an upper peripheral-wall-formation section 5A, which serves as an upper half of the peripheral wall 5. The lower structure member 14 includes the bottom wall 4 and a lower peripheral-wall-formation section 5B, which serves as a lower half of the peripheral wall 5. A lower end portion of the upper peripheral-wall-formation section 5A of the upper structure member 13 and an upper end portion of the lower peripheral-wall-formation section 5B of the lower structure member 14 have integrally formed outward flanges 13a and 14a, respectively. The outward flanges 13a and 14a of the upper and lower structure members 13 and 14 are brazed together.

A cooling-liquid flow channel 15 is provided within the casing 2 to be located between the left side wall 6 and the right side wall 7 and between the cooling-liquid inlet 11 and the cooling-liquid outlet 12. The cooling-liquid flow channel 15 extends in the front-rear direction, and cooling liquid flows through the cooling-liquid flow channel 15 from the front side to the rear side thereof.

A heat-generating body H is attached to the outer surface of the top wall 3 or the bottom wall 4 of the casing 2 (in the present embodiment, the top wall 3). A plurality of fins 16 are provided on the inner surface of a portion of the top wall 3 facing the cooling-liquid flow channel 15. The fins 16 project downward from the inner surface, and extend in the front-rear direction (in a flow direction of the cooling liquid within the cooling-liquid flow channel 15). The fins 16 are spaced from one another in the left-right direction (the width direction of the cooling-liquid flow channel 15). Two adjacent fins 16 are connected together via a connection portion 17 at their upper end portions or lower end portions. A plurality of the connection portions 17 are provided alternately at upper and lower end portions of all the fins 16. Thus, all the fins 16 and the connection portions 17 constitute a fin unit 18 (see Fig. 4). The connection portions 17 on the upper side of the fin unit 18 are welded to the inner surface of the top wall 3 of the casing 2, and the connection portions 17 on the lower side of the fin unit 18 are welded to the inner surface of the bottom wall 4 of the casing 2.

Each fin 16 of the fin unit 18 has a wavy shape as viewed on a cross section taken along a horizontal plane F perpendicular to the fin height direction of the fins 16 (vertical direction) (see Fig. 2), and includes leftward projecting wave crest portions 19 and rightward projecting wave trough portions 21 formed alternately. The fin unit 18 is manufactured from aluminum through press work, bending work, forging, or the like.

Fig. 5 shows two adjacent fins of the fin unit 18, wherein the left fin is indicated by 16A, and the right fin is indicated by 16B. As shown Fig. 5, one of the two adjacent fins 16A and 16B (in the present embodiment, the left fin 16A) is formed such that the right side surfaces 22a, facing the other fin (in the present embodiment, the right fin 16B), of two slant portions 22 connecting two adjacent wave crest portions 19 and a wave trough portion 21 located between the wave crest portions 19 intersect the above-mentioned horizontal plane F, to thereby form two lines of intersection which intersect each other at a point P1. This point P1 is located on a first straight line L1 extending in the front-rear direction. Meanwhile, the other fin; i.e., the right fin 16B, is formed such that the left side surfaces 22b, facing the left fin 16A, of two slant portions 22 connecting two adjacent wave trough portions 21 and a wave crest portion 19 located between the wave trough portions 21 intersect the above-mentioned horizontal plane F, to thereby form two lines of intersection which intersect each other at a point P2. This point P2 is located on a second straight line L2 extending in the front-rear direction. The first straight line L1 is located rightward of the second straight line L2. Therefore, as viewed on the above-mentioned horizontal plane F, the point P1 (P2) of the fin 16A (16B) is located on a side toward the adjacent opposite fin 16B (16A) in relation to a single straight line L2 (L1) extending in the front-rear direction (the flow direction of the cooling liquid). Accordingly, in the cooling-liquid flow channel 15, the cooling liquid flows, while meandering, through a flow channel section 15a between the two adjacent fins 16. Notably, the first straight line L1 and the second straight line L2 may coincide with each other.

Furthermore, in the case of the left fin 16A, an angle α is formed between the two lines of intersection between the above-mentioned horizontal plane F and the right side surfaces 22a of two slant portions 22 connecting two adjacent wave trough portions 21 and a wave crest portion 19 located therebetween; and in the case of the right fin 16B, an angle β is formed between the two lines of intersection between the above-mentioned horizontal plane F and the left side surfaces 22b of two slant portions 22 connecting two adjacent wave crest portions 19 and a wave trough portion 21 located therebetween. Preferably, each of the angles α and β falls within a range of 110 to 150 degrees. In the case where the angles α and β are excessively small, an excessively large pressure loss is produced when the cooling liquid flows through between the two adjacent fins 16. In the case where the angles α and β are excessively large, the effect of improving cooling performance may become insufficient. For reference, Fig. 6 shows the relation between the angles α, β, and pressure loss and cooling performance.

Moreover, preferably, the spacing S between the two adjacent fins 16A and 16B is 0.5 mm or greater. If the spacing S is excessively small, foreign objects, which may be contained in the cooling liquid, may be caught between the two adjacent fins 16A and 16B. Notably, the upper limit of the spacing S is about 2 mm. If the spacing S is excessively large, cooling performance may drop.

A portion of the interior of the casing 2 located upstream (frontward) of the cooling-liquid flow channel 15 serves as an inlet header section 23 communicating with the cooling-liquid inlet 11. A portion of the interior of the casing 2 located downstream (rearward) of the cooling-liquid flow channel 15 serves as an outlet header section 24 communicating with the cooling-liquid outlet 12. The internal height of the entire casing 2 is uniform; i.e., the inlet header section 23, the outlet header section 24, and the cooling-liquid flow channel 15 have the same height. Furthermore, each of the inlet header section 23 and the outlet header section 24 has a constant width (in the front-rear direction) over the entire length thereof. The inlet header section 23 has a square inflow end portion 23a, which is located on the side toward the left side wall 6 and communicates with the cooling-liquid inlet 11, and the outlet header section 24 has a square outflow end portion 24a, which is located on the side toward the right side wall 7 and communicates with the cooling-liquid outlet 12. The width (the width in the front-rear direction) of the inflow end portion 23a of the inlet header section 23 is equal to that of the outflow end portion 24a of the outlet header section 24.

The heat-generating body H, which is a semiconductor device, is joined to the outer surface of the top wall 3 of the casing 2 via a plate-shaped electrically insulating member I.

In the liquid-cooled-type cooling device 1 having the above-described configuration, a cooling liquid having flowed from the cooling-liquid inlet 11 into the inlet header section 23 through the inflow end portion 23a dividedly flows into the flow channel sections 15a of the cooling-liquid flow channel 15, each located between two adjacent fins 16. The cooling liquid then flows rearward through each flow channel section 15a.

The cooling liquid having flowed rearward along the flow channel sections 15a of the cooling-liquid flow channel 15 enters the outlet header section 24, and flows rightward within the outlet header section 24. The cooling liquid then flows out of the cooling-liquid outlet 12 via the outflow end portion 24a of the outlet header section 24 located on the side toward the right side wall 7.

Heat generated from the heat-generating body H is transmitted to the cooling liquid which flows through the flow channel sections 15a of the cooling-liquid flow channel 15, via the insulating member I, the top wall 3 of the casing 2, and the fins 16 of the fin unit 18. The heat-generating body H is thus cooled.

For reference, the relation between heat resistance and flow speed of the cooling liquid flowing through the cooling-liquid flow channel 15 of the liquid-cooled-type cooling device 1 of the above-described embodiment is shown in Fig. 7 by a solid line. Further, the relation between heat resistance and flow speed of the cooling liquid flowing through the cooling-liquid flow channel 15 of a comparative product which includes fins as shown in Fig. 10 is shown in Fig. 7 by a broken line. The results shown in Fig. 7 reveal that the liquid-cooled-type cooling device 1 of the above-described embodiment has an improved cooling performance, as compared with the comparative product having the same structure as the liquid-cooled-type cooling device described in Japanese Patent Application Laid-Open No. 2007-201181.

Notably, the results shown in Fig. 7 were obtained through computer simulation calculation performed under the conditions that the heat load from the heat-generating body H was 50 to 200 W and cooling liquid formed of water and having a temperature of 20 to 30°C was supplied to the cooling-liquid flow channel, while the flow speed of the cooling liquid was changed within a range not greater than 5 m/s.

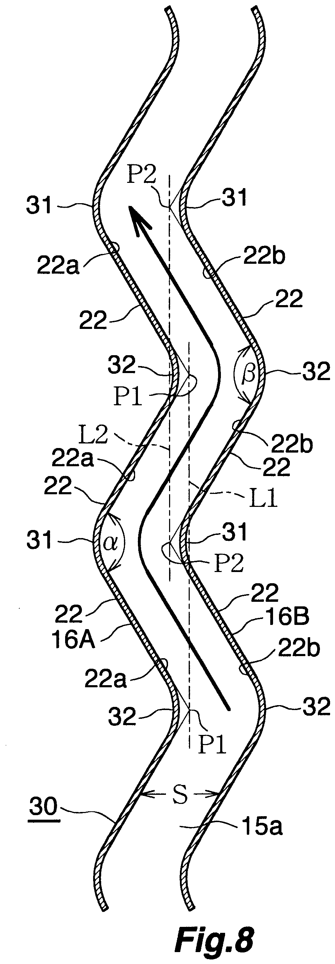

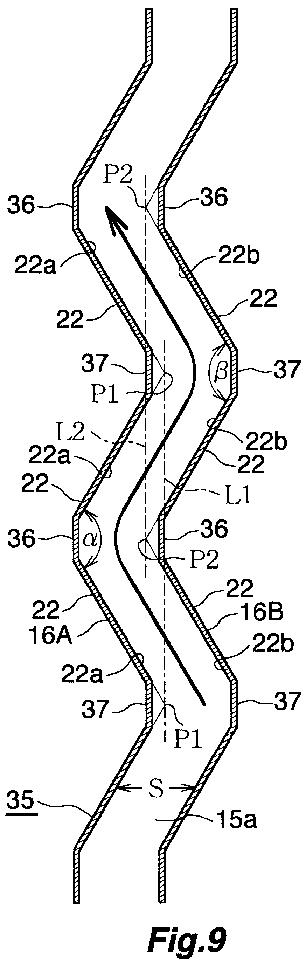

Figs. 8 and 9 show modifications of the fin unit. Notably, in Figs. 8 and 9 as well, of two adjacent fins of the fin unit, the left fin is indicated by 16A, and the right fin is indicated by 16B.

In the case of a fin unit 30 shown in Fig. 8, each of the fins 16A and 16B has a wavy shape as viewed on a cross section taken along the horizontal plane F perpendicular to the fin height direction of the fins 16A and 16B (vertical direction), and each of the leftward projecting wave crest portions 31 and the rightward projecting wave trough portions 32 is rounded.

Therefore, as viewed on the above-mentioned horizontal plane F, the point P1 of the left fin 16A, i.e., the intersection between two lines of intersection between the above-mentioned horizontal plane F and the right side surfaces 22a of two slant portions 22 connecting two adjacent wave crest portions 31 and a wave trough portion 32 located therebetween, is located at a position where imaginary lines extending rightward from the right side surfaces 22a of the two slant portions 22 intersect each other. Further, as viewed on the above-mentioned horizontal plane F, the point P2 of the right fin 16B, i.e., the intersection between two lines of intersection between the above-mentioned horizontal plane F and the left side surfaces 22b of two slant portions 22 connecting two adjacent wave trough portions 32 and a wave crest portion 31 located therebetween, is located at a position where imaginary lines extending leftward from the left side surfaces 22b of the two slant portions 22 intersect each other. As in the case of the fins 16A and 16B shown in Fig. 5, the points P1 and P2 are located on first and second straight lines L1 and L2, respectively, which extend in the front-rear direction. Since the first straight line L1 is located rightward of the second straight line L2, as viewed on the above-mentioned horizontal plane F, the point P1 (P2) of the fin 16A (16B) is located on a side toward the adjacent opposite fin 16B (16A) in relation to a single straight line L2 (L1) extending in the front-rear direction (the flow direction of the cooling liquid). Notably, the first straight line L1 and the second straight line L2 may coincide with each other.

In the case of a fin unit 35 shown in Fig. 9, each of the fins 16A and 16B has a wavy shape as viewed on a cross section taken along the horizontal plane F perpendicular to the fin height direction of the fins 16A and 16B (vertical direction), and each of the leftward projecting wave crest portions 36 and the rightward projecting wave trough portions 37 is made flat.

Therefore, as viewed on the above-mentioned horizontal plane F, the point P1 of the left fin 16A, i.e., the intersection between two lines of intersection between the above-mentioned horizontal plane F and the right side surfaces 22a of two slant portions 22 connecting two adjacent wave crest portions 36 and a wave trough portion 37 located therebetween, is located at a position where imaginary lines extending rightward from the right side surfaces 22a of the two slant portions 22 intersect each other. Further, as viewed on the above-mentioned horizontal plane F, the point P2 of the right fin 16B, i.e., the intersection between two lines of intersection between the above-mentioned horizontal plane F and the left side surfaces 22b of two slant portions 22 connecting two adjacent wave trough portions 37 and a wave crest portion 36 located therebetween, is located at a position where imaginary lines extending leftward from the left side surfaces 22b of the two slant portions 22 intersect each other. As in the case of the fins 16A and 16B shown in Fig. 5, the points P1 and P2 are located on first and second straight lines L1 and L2, respectively, which extend in the front-rear direction. Since the first straight line L1 is located rightward of the second straight line L2, as viewed on the above-mentioned horizontal plane F, the point P1 (P2) of the fin 16A (16B) is located on a side toward the adjacent opposite fin 16B (16A) in relation to a single straight line L2 (L1) extending in the front-rear direction (the flow direction of the cooling liquid). Notably, the first straight line L1 and the second straight line L2 may coincide with each other.

In the fin units 30 and 35 shown in Figs. 8 and 9, each of the angles α and β of the left and right fins 16A and 16B are preferably falls within a range of 110 to 150 degrees, and the spacing S between the two adjacent fins 16A and 16B is preferably 0.5 mm or greater, as in the case of the fin unit 18 shown in Fig. 5. Notably, as described before, the angle α is an angle of the left fin 16A formed between two lines of intersection between the above-mentioned horizontal plane F and the right side surfaces 22a of two slant portions 22 connecting two adjacent wave trough portions 21 and a wave crest portions 19 located therebetween; and the angle β is an angle of the right fin 16B formed between two lines of intersection between the above-mentioned horizontal plane F and the left side surfaces 22b of two slant portions 22 connecting two adjacent wave crest portions 19 and a wave trough portion 21 located therebetween.

In the above-described embodiments, of all the fins 16, two adjacent fins 16 are connected together via the connection portion 17. However, the structure of the fins is not limited thereto. The fins 16 may be individually fixed to or integrally formed on the inner surface of a portion (facing the cooling-liquid flow channel 15) of a selected wall (the top wall 3 or the bottom wall 4) of the casing 2 onto which a heat-generating body is mounted such that the heat-generating body is in contact with the outer surface of the selected wall.

In the above-described embodiments, a cooling-liquid inlet is formed in one end portion of the left side wall 6 of the peripheral wall 5 of the casing 2, and a cooling-liquid outlet is formed in the opposite end portion of the right side wall 7 of the peripheral wall 5 of the casing 2. However, the arrangement of the cooling-liquid inlet and the cooling-liquid outlet is not limited thereto. The cooling-liquid inlet may be formed in one end portion of a wall selected from the left side wall 6 and the right side wall 7, and the cooling-liquid outlet may be formed in the opposite end portion of the selected wall. Alternatively, the cooling-liquid inlet and the cooling-liquid outlet may be formed in the top wall or the bottom wall of the casing such that they are spaced from each other.

## Claims

1. A liquid-cooled-type cooling device (1) comprising a casing (2) which has a top wall (3), a bottom wall (4), and a peripheral wall (5), which has a cooling-liquid inlet (11) and a cooling-liquid outlet (12) formed thereon, and in which a cooling-liquid flow channel (15) is provided between the cooling-liquid inlet and the cooling-liquid outlet, wherein
a plurality of fins projecting into the cooling-liquid flow channel and extending in a flow direction of cooling liquid within the cooling-liquid flow channel are provided on an inner surface of a portion of a wall selected from the top wall and the bottom wall of the casing onto which a heat-generating body (H) is attached such that the heat-generating body is in contact with an outer surface of the selected wall, the portion of the selected wall facing the cooling-liquid flow channel, and the plurality of fins being spaced from one another in a width direction of the cooling-liquid flow channel;
each of the fins (16) has a wavy shape as viewed on a cross section taken along a horizontal plane perpendicular to a height direction of the fins, and has wave crest portions (31) and wave trough portions (32) alternately formed thereon;
the fins are configured and arranged such that the cooling liquid flows between two adjacent fins while meandering;
a first fin (16A) of two adjacent fins (16A, 16B) is configured such that two lines of intersection formed between the horizontal plane (F) and second-fin-side surfaces (22a) of two slant portions (22) connecting two adjacent wave crest portions (31) and a wave trough portion (32) located therebetween intersect each other at a point (P1) located on a first straight line (L1);
the wave crest portions (31) and the wave trough portions (32) of each fin (16) are rounded; and, as viewed on the horizontal plane, the point (P1) at which the two lines of intersection between the horizontal plane and the second-fin-side surfaces (22a) of the two slant portions (22) intersect each other is located at a position at which imaginary lines extending toward the second fin (16B) from the second-fin-side surfaces (22a) of the two slant portions (22) intersect each other;
a second fin (16B) of the two adjacent fins (16A, 16B) is configured such that two lines of intersection formed between the horizontal plane and first-fin-side surfaces (22b) of two slant portions (22) connecting two adjacent wave trough portions (32) and a wave crest portion (31) located therebetween intersect each other at a point (P2) located on a second straight line (L2);
the first straight line (L1) is located on a side toward the second fin (16B) in relation to the second straight line (L2), and as viewed on the horizontal plane, the first straight line (L1) intersects only with the second fin (16B), and a set of two adjacent fins (16A, 16B) is provided adjacent to another set of two adjacent fins so that the first straight line (L1) of a first set of fins is located between the second straight line (L2) of the first set of fins and the second straight line (L2) of a second set of fins,
**characterized in that** a first fin (16A) has a surface (22a) facing a second fin (16B) such that two lines of the surface (22a) extended from two slant portions (22) of the first fin (16A) converge to intersect each other at a point (P1) located beyond the trough portion (32) of the first fin (16A), and respective points (P1) associated with each trough portion (32) of the first fin (16A) are located on a side toward the first fin (16A) in relation to the center portion between the trough portion (32) of the first fin (16A) and the trough portion (32) of the second fin (16B) adjacent to the first fin (16A), and
a second fin (16B) has a surface (22b) facing a first fin (16A) such that two lines of the surface (22b) extended from two slant portions (22) of the second fin (16B) converge to intersect each other at a point (P2) located beyond the wave crest (31) of the second fin (16B), and respective points (P2) associated with each wave crest (31) of the second fin (16B) are located on a side toward the second fin (16B) in relation to the center portion between the wave crest (31) of the second fin (16B) and the wave crest (31) of the first fin (16A) adjacent to the second fin (16B).

2. A liquid-cooled-type cooling device according to claim 1, wherein the first fin of two adjacent fins is configured such that the two lines of intersection formed between the horizontal plane and the second-fin-side surfaces of two slant portions connecting two adjacent wave trough portions and a wave crest portion located therebetween form an angle **(α)** of 110 to 150 degrees therebetween; and the second fin of the two adjacent fins is configured such that the two lines of intersection formed between the horizontal plane and the first-fin-side surfaces of two slant portions connecting two adjacent wave crest portions and a wave trough portion located therebetween form an angle **(β)** of 110 to 150 degrees therebetween.

3. A liquid-cooled-type cooling device according to claim 1, wherein two adjacent fins have a spacing (S) of 0.5 mm or greater therebetween.

4. A liquid-cooled-type cooling device according to claim 1, wherein two adjacent fins are connected together at their upper end portions or lower end portions via a connection portion, and a plurality of the connection portions are provided alternately at upper and lower end portions of all the fins, whereby all the fins and the connection portions constitute a fin unit; and the connection portions on the upper side of the fin unit are joined to the top wall of the casing, and the connection portions on the lower side of the fin unit are joined to the bottom wall of the casing.

5. A liquid-cooled-type cooling device according to claim 1, wherein each wave crest portion (31) of the first fin (16A) is aligned with a wave crest portion (31) of the second fin (16B) along the width direction, and each wave trough portion (32) of the first fin (16A) is aligned with a wave trough portion (32) of the second fin (16B) along the width direction.

## Patentansprüche

1. Kühlvorrichtung (1) vom flüssigkeitsgekühlten Typ, umfassend ein Gehäuse (2), das eine obere Wand (3), eine untere Wand (4) und eine Umfassungswand (5) aufweist, das daran ausgebildet einen Kühlflüssigkeitseinlass (11) und einen Kühlflüssigkeitsauslass (12) aufweist, und in dem zwischen dem Kühlflüssigkeitseinlass und dem Kühlflüssigkeitsauslass ein Kühlflüssigkeits-Strömungskanal (15) bereitgestellt ist, wobei
mehrere Rippen, die in den Kühlflüssigkeits-Strömungskanal vorstehen und sich in einer Strömungsrichtung von Kühlflüssigkeit innerhalb des Kühlflüssigkeits-Strömungskanals erstrecken, an einer inneren Oberfläche eines Abschnitts einer aus der oberen Wand und der unteren Wand des Gehäuses ausgewählten Wand bereitgestellt sind, an der ein wärmeerzeugender Körper (H) derart befestigt ist, dass der wärmeerzeugende Körper mit einer äußeren Oberfläche der ausgewählten Wand in Kontakt ist, wobei der Abschnitt der ausgewählten Wand dem Kühlflüssigkeits-Strömungskanal zugewandt ist und die mehreren Rippen in einer Breitenrichtung des Kühlflüssigkeits-Strömungskanals voneinander beabstandet sind,
jede der Rippen (16), im Querschnitt entlang einer waagrechten Ebene im rechten Winkel zu einer Höhenrichtung der Rippen gesehen, eine wellige Gestalt aufweist und abwechselnd daran ausgebildet Wellenbergabschnitte (31) und Wellentalabschnitte (32) aufweist,
die Rippen derart ausgebildet und angeordnet sind, dass die Kühlflüssigkeit zwischen zwei benachbarten Rippen strömt und sich dabei mäanderförmig bewegt,
eine erste Rippe (16A) von zwei benachbarten Rippen (16A, 16B) derart ausgebildet ist, dass zwei Kreuzungslinien, die zwischen der waagrechten Ebene (F) und zweitrippenseitigen Oberflächen (22a) von zwei schrägen Abschnitten (22), die zwei benachbarte Wellenbergabschnitte (31) und einen dazwischen angeordneten Wellentalabschnitt (32) verbinden, gebildet werden, einander an einem Punkt (P1) kreuzen, der auf einer ersten geraden Linie (L1) angeordnet ist,
die Wellenbergabschnitte (31) und die Wellentalabschnitte (32) jeder Rippe (16) gerundet sind und, auf der waagrechten Ebene gesehen, der Punkt (P1), an dem die zwei Kreuzungslinien zwischen der waagrechten Ebene und den zweitrippenseitigen Oberflächen (22a) der zwei schrägen Abschnitte (22) einander kreuzen, an einer Position angeordnet ist, an der imaginäre Linien, die sich von den zweitrippenseitigen Oberflächen (22a) der zwei schrägen Abschnitte (22) in Richtung der zweiten Rippe (16B) erstrecken, einander kreuzen,
eine zweite Rippe (16B) von den zwei benachbarten Rippen (16A, 16B) derart ausgebildet ist, dass zwei Kreuzungslinien, die zwischen der waagrechten Ebene und erstrippenseitigen Oberflächen (22b) von zwei schrägen Abschnitten (22), die zwei benachbarte Wellentalabschnitte (32) und einen dazwischen angeordneten Wellenbergabschnitt (31) verbinden, gebildet werden, einander an einem Punkt (P2) kreuzen, der auf einer zweiten geraden Linie (L2) angeordnet ist,
die erste gerade Linie (L1) in Bezug auf die zweite gerade Linie (L2) auf einer Seite zu der zweiten Rippe (16B) hin angeordnet ist und, auf der waagrechten Ebene gesehen, die erste gerade Linie (L1) nur die zweite Rippe (16B) kreuzt, und ein Satz von zwei benachbarten Rippen (16A, 16B) einem anderen Satz von zwei benachbarten Rippen benachbart bereitgestellt ist, so dass die erste gerade Linie (L1) eines ersten Satzes von Rippen zwischen der zweiten geraden Linie (L2) des ersten Satzes von Rippen und der zweiten geraden Linie (L2) eines zweiten Satzes von Rippen angeordnet ist,
**dadurch gekennzeichnet, dass** eine erste Rippe (16A) eine Oberfläche (22a) aufweist, die einer zweiten Rippe (16B) zugewandt ist, derart, dass zwei Linien der Oberfläche (22a), die sich von zwei schrägen Abschnitten (22) der ersten Rippe (16A) weg erstrecken, konvergieren, um einander an einem Punkt (P1) zu kreuzen, der jenseits des Talabschnitts (32) der ersten Rippe (16A) angeordnet ist, und jeweilige Punkte (P1), die jedem Talabschnitt (32) der ersten Rippe (16A) zugeordnet sind, in Bezug auf den Mittelabschnitt zwischen dem Talabschnitt (32) der ersten Rippe (16A) und dem Talabschnitt (32) der zweiten Rippe (16B), die der ersten Rippe (16A) benachbart ist, auf einer Seite zu der ersten Rippe (16A) hin angeordnet sind, und
eine zweite Rippe (16B) eine Oberfläche (22b) aufweist, die einer ersten Rippe (16A) zugewandt ist, derart, dass zwei Linien der Oberfläche (22b), die sich von zwei schrägen Abschnitten (22) der zweiten Rippe (16B) weg erstrecken, konvergieren, um einander an einem Punkt (P2) zu kreuzen, der jenseits des Wellenbergs (31) der zweiten Rippe (16B) angeordnet ist, und jeweilige Punkte (P2), die jedem Wellenberg (31) der zweiten Rippe (16B) zugeordnet sind, in Bezug auf den Mittelabschnitt zwischen dem Wellenberg (31) der zweiten Rippe (16B) und dem Wellenberg (31) der ersten Rippe (16A), die der zweiten Rippe (16B) benachbart ist, auf einer Seite zu der zweiten Rippe (16B) hin angeordnet sind.

2. Kühlvorrichtung vom flüssigkeitsgekühlten Typ nach Anspruch 1, wobei die erste Rippe von zwei benachbarten Rippen derart ausgebildet ist, dass die zwei Kreuzungslinien, die zwischen der waagrechten Ebene und den zweitrippenseitigen Oberflächen von zwei schrägen Abschnitten, die zwei benachbarte Wellentalabschnitte und einen dazwischen angeordneten Wellenbergabschnitt verbinden, gebildet werden, dazwischen einen Winkel (α) von 110 bis 150 Grad bilden, und die zweite Rippe der zwei benachbarten Rippen derart ausgebildet ist, dass die zwei Kreuzungslinien, die zwischen der waagrechten Ebene und den erstrippenseitigen Oberflächen von zwei schrägen Abschnitten, die zwei benachbarte Wellenbergabschnitte und einen dazwischen angeordneten Wellentalabschnitt verbinden, gebildet werden, dazwischen einen Winkel (β) von 110 bis 150 Grad bilden.

3. Kühlvorrichtung vom flüssigkeitsgekühlten Typ nach Anspruch 1, wobei zwei benachbarte Rippen eine Beabstandung (S) von 0,5 mm oder größer dazwischen aufweisen.

4. Kühlvorrichtung vom flüssigkeitsgekühlten Typ nach Anspruch 1, wobei zwei benachbarte Rippen an deren oberen Endabschnitten oder unteren Endabschnitten über einen Verbindungsabschnitt miteinander verbunden sind und mehrere der Verbindungsabschnitte abwechselnd an oberen und unteren Endabschnitten aller Rippen bereitgestellt sind, wodurch alle Rippen und die Verbindungsabschnitte eine Rippeneinheit bilden, und die Verbindungsabschnitte an der oberen Seite der Rippeneinheit mit der oberen Wand des Gehäuses verbunden sind und die Verbindungsabschnitte an der unteren Seite der Rippeneinheit mit der unteren Wand des Gehäuses verbunden sind.

5. Kühlvorrichtung vom flüssigkeitsgekühlten Typ nach Anspruch 1, wobei jeder Wellenbergabschnitt (31) der ersten Rippe (16A) entlang der Breitenrichtung mit einem Wellenbergabschnitt (31) der zweiten Rippe (16B) ausgerichtet ist und jeder Wellentalabschnitt (32) der ersten Rippe (16A) entlang der Breitenrichtung mit einem Wellentalabschnitt (32) der zweiten Rippe (16B) ausgerichtet ist.

## Revendications

1. Dispositif de refroidissement de type refroidi par liquide (1) comprenant un boîtier (2) qui comporte une paroi supérieure (3), une paroi inférieure (4), et une paroi périphérique (5), qui comporte une entrée de liquide de refroidissement (11) et une sortie de liquide de refroidissement (12) formées sur celui-ci, et dans lequel un canal d'écoulement de liquide de refroidissement (15) est disposé entre l'entrée de liquide de refroidissement et la sortie de liquide de refroidissement, dans lequel une pluralité d'ailettes faisant saillie dans le canal d'écoulement de liquide de refroidissement et s'étendant dans une direction d'écoulement de liquide de refroidissement dans le canal d'écoulement de liquide de refroidissement sont disposées sur une surface interne d'une partie d'une paroi choisie parmi la paroi supérieure et la paroi inférieure du boîtier sur laquelle un corps de génération de chaleur (H) est fixé de sorte que le corps de génération de chaleur soit en contact avec une surface externe de la paroi sélectionnée, la partie de la paroi sélectionnée faisant face au canal d'écoulement de liquide de refroidissement, et la pluralité d'ailettes étant espacées les unes des autres dans une direction de largeur du canal d'écoulement de liquide de refroidissement ;
chacune des ailettes (16) a une forme ondulée en observant sur une section transversale prise le long d'un plan horizontal perpendiculaire à la direction de la hauteur des ailettes, et comporte des parties de crête d'onde (31) et des parties de vallée d'onde (32) formées de façon alternée sur celle-ci ;
les ailettes sont configurées et agencées de sorte que le liquide de refroidissement s'écoule entre deux ailettes adjacentes de façon sinueuse ;
une première ailette (16A) de deux ailettes adjacentes (16A, 16B) est configurée de sorte que deux lignes d'intersection formées entre le plan horizontal (F) et des surfaces côté deuxième ailette (22a) de deux parties inclinées (22) reliant deux parties de crête d'onde adjacentes (31) et une partie de vallée d'onde (32) située entre celles-ci se coupent mutuellement à un point (P1) situé sur une première ligne droite (L1) ;
la parties de crête d'onde (31) et les parties de vallée d'onde (32) de chaque ailette (16) sont arrondies ; et, en observant sur le plan horizontal, le point (P1) auquel les deux lignes d'intersection entre le plan horizontal et les surfaces côté deuxième ailette (22a) des deux parties inclinées (22) se coupent mutuellement est situé à une position à laquelle des lignes imaginaires s'étendant vers la deuxième ailette (16B) depuis les surfaces côté deuxième ailette (22a) des deux parties inclinées (22) se coupent mutuellement ;
une deuxième ailette (16B) des deux ailettes adjacentes (16A, 16B) est configurée de sorte que deux lignes d'intersection formées entre le plan horizontal et des surfaces côté première ailette (22b) de deux parties inclinées (22) reliant deux parties de vallée d'onde (32) adjacentes et une partie de crête d'onde (31) située entre celles-ci se coupent mutuellement à un point (P2) situé sur une deuxième ligne droite (L2) ;
la première ligne droite (L1) est située sur un côté vers la deuxième ailette (16B) par rapport à la deuxième ligne droite (L2), et en observant sur le plan horizontal, la première ligne droite (L1) coupe uniquement la deuxième ailette (16B), et un ensemble de deux ailettes adjacentes (16A, 16B) est disposé en position adjacente à un autre ensemble de deux ailettes adjacentes de sorte que la première ligne droite (L1) d'un premier ensemble d'ailettes soit située entre la deuxième ligne droite (L2) du premier ensemble d'ailettes et la deuxième ligne droite (L2) d'un deuxième ensemble d'ailettes,
**caractérisé en ce qu'**une première ailette (16A) comporte une surface (22a) faisant face à une deuxième ailette (16B) de sorte que deux lignes de la surface (22a) s'étendant depuis deux parties inclinées (22) de la première ailette (16A) convergent de façon à se couper mutuellement à un point (P1) situé au-delà de la partie de vallée (32) de la première ailette (16A), et les points (P1) respectifs associés à chaque partie de vallée (32) de la première ailette (16A) sont situés sur un côté vers la première ailette (16A) par rapport à la partie centrale entre la partie de vallée (32) de la première ailette (16A) et la partie de vallée (32) de la deuxième ailette (16B) adjacente à la première ailette (16A), et
une deuxième ailette (16B) comporte une surface (22b) faisant face à une première ailette (16A) de sorte que deux lignes de la surface (22b) s'étendant depuis deux parties inclinées (22) de la deuxième ailette (16B) convergent de façon à se couper mutuellement à un point (P2) situé au-delà de la crête d'onde (31) de la deuxième ailette (16B), et les points (P2) respectifs associés à chaque crête d'onde (31) de la deuxième ailette (16B) sont situés sur un côté vers la deuxième ailette (16B) par rapport à la partie centrale entre la crête d'onde (31) de la deuxième ailette (16B) et la crête d'onde (31) de la première ailette (16A) adjacente à la deuxième ailette (16B).

2. Dispositif de refroidissement de type refroidi par liquide selon la revendication 1, dans lequel la première ailette de deux ailettes adjacentes est configurée de sorte que les deux lignes d'intersection formées entre le plan horizontal et les surfaces côté deuxième ailette de deux parties inclinées reliant deux parties de vallée d'onde adjacentes et une partie de crête d'onde située entre celles-ci forment un angle (a) de 110 à 150 degrés entre celles-ci ; et la deuxième ailette des deux ailettes adjacentes est configurée de sorte que les deux lignes d'intersection formées entre le plan horizontal et les surfaces côté première ailette de deux parties inclinées reliant deux parties de crête d'onde adjacentes et une partie de vallée d'onde située entre celles-ci forment un angle (β) de 110 à 150 degrés entre celles-ci.

3. Dispositif de refroidissement de type refroidi par liquide selon la revendication 1, dans lequel deux ailettes adjacentes ont un espacement (S) de 0,5 mm ou plus entre celles-ci.

4. Dispositif de refroidissement de type refroidi par liquide selon la revendication 1, dans lequel deux ailettes adjacentes sont reliées conjointement au niveau de leurs parties d'extrémité supérieure ou parties d'extrémité inférieure par l'intermédiaire d'une partie de raccordement, et une pluralité des parties de raccordement sont disposées de façon alternée au niveau des parties d'extrémité supérieure et inférieure de toutes les ailettes, dans lequel toutes les ailettes et les parties de raccordement constituent une unité d'ailette ; et les parties de raccordement sur le côté supérieur de l'unité d'ailette sont assemblées à la paroi supérieure du boîtier, et les parties de raccordement sur le côté inférieur de l'unité d'ailette sont assemblées à la paroi inférieure du boîtier.

5. Dispositif de refroidissement de type refroidi par liquide selon la revendication 1, dans lequel chaque partie de crête d'onde (31) de la première ailette (16A) est alignée avec une partie de crête d'onde (31) de la deuxième ailette (16B) le long de la direction de la largeur, et chaque partie de vallée d'onde (32) de la première ailette (16A) est alignée avec une partie de vallée d'onde (32) de la deuxième ailette (16B) le long de la direction de la largeur.
